# EUROPEAN PATENT SPECIFICATION

(11) **EP 0 841 690 B1**
(45) Date of publication and mention of the grant of the patent: **01.03.2006**
(21) Application number: 96308176.5
(22) Date of filing: 12.11.1996
(51) Int. Cl.: H01L 21/285, H01L 21/768

(54) **Tungsten nitride (WNx) layer manufacturing method and metal wiring manufacturing method**
Herstellungsverfahren für eine Wolframnitridschicht und metallische Leiterbahnen
Procédé de fabrication d'une couche de nitrure de tungstène (WNx) et méthode de formation d'un câblage métallique

(43) Date of publication of application: 13.05.1998
(73) Proprietor: SAMSUNG ELECTRONICS CO., LTD., Suwon-City, Kyungki-do (KR)
(72) Inventor: Park, Byung-lyul, Mapo-gu, Seoul (KR); Ha, Jung-min, Kangnam-gu, Seoul (KR); Ko, Dae-hong, Bundang-gu, Seongnam-city, Kyungki-do (KR); Lee, Sang-in, Suwon-city, Kyungki-do (KR)
(74) Representative: Kyle, Diana

(56) References cited:
- US-A- 5 429 989
- US-A- 5 487 923
- PATENT ABSTRACTS OF JAPAN vol. 015, no. 502 (E-1147), 18 December 1991 & JP 03 220720 A (HITACHI LTD), 27 September 1991,

## Description

The present invention relates to a method for manufacturing a semiconductor device. In particular aspects, it relates to a method for manufacturing a tungsten nitride (WNₓ) layer which is selectively formed in a contact hole.

JP 03-220720 A describes a semiconductor device in which the diffusion of a base electrode (Au) to the wiring material (Al) is reduced by forming a tungsten nitride film when a collector hole is buried by selective deposition of a tungsten film by CVD.

US-A-5487923 relates to a method for depositing tungsten nitride thin films prior to formation of tungsten thin films by plasma-enhanced CVD which uses WF₆₋H₂ reactant gas, in which the tungsten nitride layer prevents corrosion of the silicon semiconductor substrate by the fluorine atoms during deposition of the tungsten layer.

US-A-5429989 relates to a method of making a semiconductor device wherein, in one embodiment, a titanium silicide ohmic layer is formed on a semiconductor substrate exposed by a contact hole etched in an insulating layer; and a tungsten nitride diffusion barrier layer is subsequently deposited in the contact hole and a metal layer formed thereon.

With an increase in the integration level of semiconductor integrated circuits (ICs), the width of a metal interconnection line is required to decrease and the aspect ratio of a contact hole is required to continue to increase. However, aluminum (Al) alloy films currently being used as materials for metal wiring show bad step coverage in a contact hole or cause voids due to their formation by sputtering. As a result, shorts occur between metal interconnection lines, thereby lowering the reliability of ICs. Therefore, selective chemical vapor deposition-tungsten (SCVD-W) has attracted much attention for the use of tungsten (W) as the material for metal wiring by CVD.

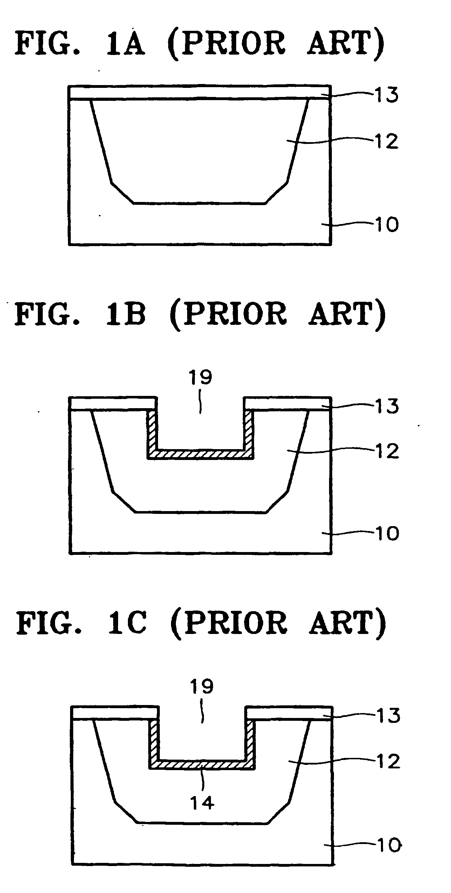

FIGS. 1A through 1E illustrate a method for forming a tungsten layer by CVD.

In FIG. 1A, an impurity region 12 for defining a source/drain region is formed by implanting ions into a silicon substrate 10. Then, a silicon oxide layer is formed as an insulating layer 13 to a thickness of 500-2000Å (10Å = 1nm) on the overall surface of the substrate 10 including the impurity region 12. As shown in FIG. 1B, a trench 19 for forming a metal wiring therein is formed by etching the insulating layer 13 and the silicon substrate 10 to a predetermined depth.

Subsequently, a titanium (Ti) layer is deposited to a thickness of 200-1500Å, on the insulating layer 13 and in the trench 19, and thermally treated. As a result of the thermal treatment, the silicon substrate 10 reacts with the Ti layer, thus forming a titanium silicide (TiSix) layer 14 acting as an ohmic layer only on the contact surface with the substrate. Then, the remaining Ti which did not react with the substrate is removed by wet etching, and the resultant shown in FIG. 1C is obtained.

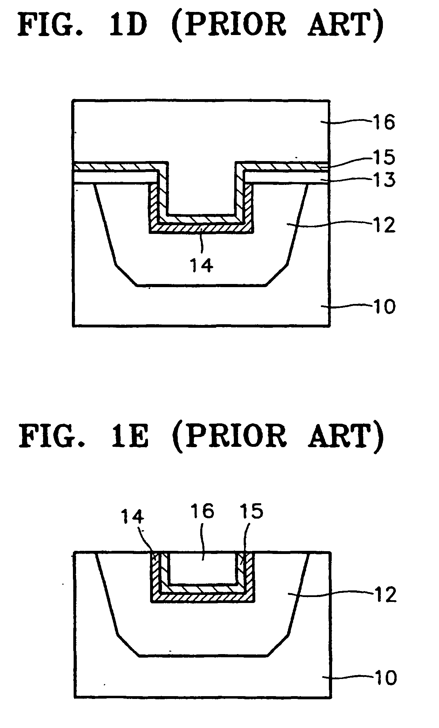

Thereafter, as shown in FIG. 1D, a titanium nitride (TiN) layer is deposited as a diffusion-barrier layer 15 to a thickness of 150-900Å and a tungsten layer 16 is deposited on the diffusion-barrier layer 15 to a thickness of 1000Å or above.

Then, the resultant is etched back by chemical mechanical polishing (CMP) so that the tungsten layer 16 remains only in the trench 19 as shown in FIG. 1E, thus, completing the metal wiring.

As described above, however, when metal wiring is formed by SCVD-W, the TiN layer acting as a diffusion-barrier layer has physical properties, for example, tensile force, different from those of the W layer being a metal wiring layer, and the interface between the layers is highly stressed. Consequently, the tungsten layer is lifted, especially the TiN layer/W layer which may be lifted from the insulation layer during CMP, in which physical force is applied.

On the other hand, when the impurity region is formed of boron (B), being a P⁺ impurity, the impurity reacts with Ti in a subsequent thermal process, thus forming TiB₂. As a result, the ohmic contact characteristics are degraded, and contact resistance is increased.

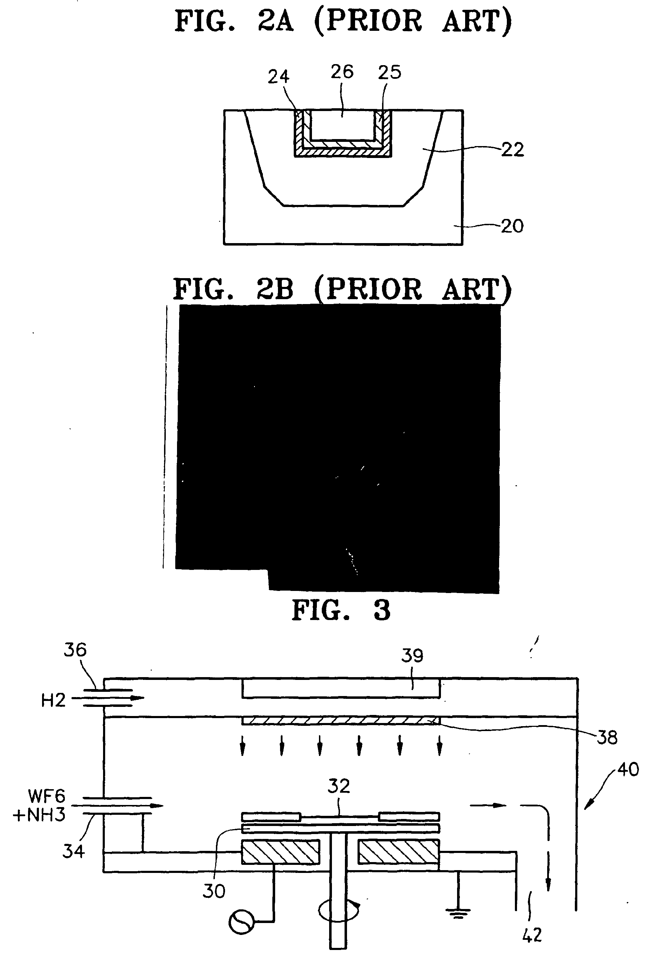

To overcome the above problem, a method as shown in FIG. 2A has been suggested in which a tungsten layer 24 is formed as an ohmic layer and then a tungsten nitride layer 25 is formed as a diffusion-barrier layer on an impurity area 22 formed on a silicon substrate 20 and then a tungsten layer 26 is formed as a metal wiring layer.

In the above method, the tungsten layer 24 being an ohmic layer is formed to a thickness of 200-1500Å by flowing tungsten fluoride (WF₆) at 6sccm and hydrogen (H₂) at 200sccm, respectively, at a deposition temperature of 600°C under a pressure of 0.1Torr (1Torr = 133Pa). Then, the tungsten nitride layer 25 being a diffusion-barrier layer is deposited to a thickness of 150-900Å, and the tungsten layer 26 is deposited to a thickness of 1000Å or above on the tungsten nitride layer 25. The resultant is etched back, thus completing a metal wiring. A section of the metal wiring is shown in a scanning electron microscopy (SEM) photo of FIG. 2B.

However, the tungsten layer formed as an ohmic layer shows excellent adhesion to silicon, whereas reduction reaction of tungsten with silicon for forming tungsten silicide leads to encroachment on a silicon substrate and thus deterioration in the electrical characteristics thereof, as shown in FIG. 2B. Encroachment is becoming a more serious problem in the ULSI era in which junction depth is decreased to 0.1µm or less. Furthermore, since tungsten reacts with Si at 550°C or above, it is difficult to apply the above metal wiring manufacturing method to manufacturing process of semiconductor device when a subsequent process must be performed at a temperature higher than 550°C.

To overcome the above problems, the object of the present invention is to provide a method for manufacturing metal wiring for a semiconductor device.

The invention provides a method of manufacturing a metal wiring for a semiconductor device, comprising the steps of:
(a) forming an insulating layer on a semiconductor substrate having a conductive layer formed thereon;
(b) forming a contact hole by etching said insulating layer to expose said conductive layer;
(c) forming an ohmic layer by depositing tungsten silicide on the conductive layer exposed by said contact hole;
(d) forming a diffusion-barrier layer by subsequently selectively depositing a tungsten nitride layer in situ on said ohmic layer and sidewalls of the contact hole by reacting a nitrogen-containing gas and a tungsten source gas by controlling flow rates of the gases such that the flow rate of the nitrogen-containing gas is from 2 to 7 times the flow rate of the tungsten source gas, so as to prevent formation of a tungsten nitride layer on the insulating layer outside the contact hole; and
(e) depositing a metal layer on said diffusion-barrier layer.

In a particular embodiment of the invention step (d) comprises reacting the gas mixture of the nitrogen-containing gas and the tungsten source gas with a reducing agent gas.

In preferred embodiments of the present invention, it is preferable to use one of WF₆ and WCl₆ as the tungsten source gas, one of N₂, NH₃, and methyl hydrazine as the nitrogen-containing gas, and one of H₂, SiH₄, SiH₁Cl₃, SiH₂Cl₂, and PH₃ as the reducing agent gas.

The flow-rate ratio of the nitrogen-containing gas to the tungsten source gas is 2-7. The flow-rate ratio of the reducing agent gas to the tungsten source gas is 0-500, more preferably 20-50.

Examples for aiding understanding the present invention are described in detail below, by way of example, with reference to the attached drawings, in which:
FIGS. 1A through 1E are sectional views explaining a conventional method for manufacturing a metal wiring structure of Ti/TiN/W;
FIG. 2A is a sectional view explaining a conventional method for manufacturing a metal wiring structure of W/WNₓ/W
FIG. 2B is an SEM photo showing a section of the metal wiring shown in FIG. 2A;
FIG. 3 is a sectional view of a process chamber for depositing a WNₓ layer;
FIGS. 4A through 4D are SEM photos showing sections of a TiN layer which selectively grows according to the flow rate of NH₃ gas;
FIG. 5 is a graph showing X-ray diffraction results of the WN layer;
FIGS. 6A through 6D are sectional views explaining a method for manufacturing a metal wiring of a semiconductor device;
FIGS. 7A and 7B are sectional views explaining a method for manufacturing a metal wiring of a semiconductor device; and
FIGS. 8A through 8E are sectional views of a method for manufacturing a metal wiring of a semiconductor device.

### WNₓ layer growing device

FIG. 3 is a sectional view of a CVD process chamber for depositing a WNₓ layer.

Referring to FIG. 3, a susceptor 30 for loading a wafer thereon is installed in the lower part of a process chamber 40. An IR lamp 39 is installed in the upper part to heat the temperature of a wafer 32 to a temperature appropriate for reaction. A tungsten source gas and a nitrogen-containing gas are injected through a first gas inlet 34 and flow horizontally across the wafer 32 loaded on the susceptor 30. A reducing agent gas is injected through a second gas inlet 36, flow vertically to the wafer 32 through a mesh nozzle 38, and react with the gases introduced from the first gas inlet 34, thereby forming a WNₓ layer on the wafer 32. The gases are exhausted through an outlet 42 opposing the first and second gas inlets 34 and 36 after the reaction.

### Manufacture of WN layer

Contamination sources which might be produced in the process chamber 40 are minimized by setting the process chamber at near vacuum of 10⁻⁶Torr or below. Then, the susceptor 30 is loaded with a silicon substrate having an impurity region formed thereon or a silicon substrate including an underlying metal wiring layer which is formed of one of a pure metal such as aluminum (A1), tungsten (W), molybdenum (Mo), cobalt (Co), titanium (Ti), copper (Cu), and platinum (Pt), their silicide compound, and their alloy. The process chamber 40 is heated to 200-700°C by the IR lamp 39, and then reactive gases are introduced through the first and second gas inlets 34 and 36, preferably at a pressure of 0.01-1Torr. Here, it is preferable to use WF₆ or WCl₆ as the tungsten source gas and methyl hydrazine, N₂, or NH₃ as the nitrogen-containing gas injected through the first gas inlet 34. Preferably, one of H₂, SiH₄, SiH₁Cl₃, SiH₂Cl₂ , and PH₃ is used as the reducing agent gas injected through the second gas inlet 36. The flow-rate ratio of the nitrogen-containing gas to the tungsten source gas is preferably 0.5-100, and more preferably 2-7. The flow-rate ratio of the reducing agent gas to the tungsten source gas is preferably 0-500, and more preferably 20-50.

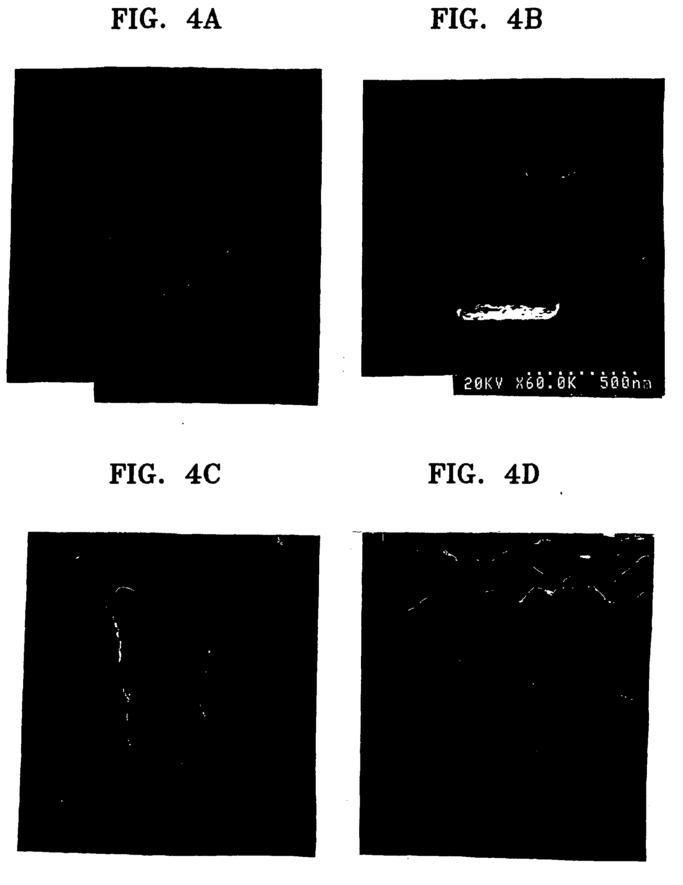

FIGS. 4A to 4D are SEM photos showing the growth of WNₓ layers depending on the flow-rate ratio of NH₃ gas to a tungsten source gas.

After a silicon substrate having a contact hole formed therein is loaded in the CVD process chamber 40 of FIG. 3, WNₓ layers are formed by varying the flow-rate of the NH₃ gas to 0, 10, 20, and 40sccm, under the fixed conditions of a deposition temperature of 600°C, a pressure of 0.1Torr, a flow rate of WF₆ of 6sccm, and a flow rate of H₂ of 200sccm. The results are illustrated in the SEM photos of FIGS. 4A to 4D.

From the photo of FIG. 4A showing only a pure tungsten layer are formed in the contact hole it is noted that the tungsten layer seriously encroached on the substrate, which is a problem of the prior art. On the other hand, with a flow-rate of NH₃ of 10sccm, the encroachment was suppressed as shown in FIG. 4B, whereas a thin film seldom grew and a nucleus was formed only on the bottom surface of a contact hole. With a flow-rate of NH₃ of 20sccm, a WNₓ layer grew selectively only on the substrate portion and sidewalls of a contact hole, and not on a silicon oxide layer, as shown in FIG. 4C. However, as shown in FIG. 4D, with a flow-rate of NH₃ of 40 sccm, characteristics of selective deposition of the WNₓ layer disappeared and it grew on the entire surface of the substrate.

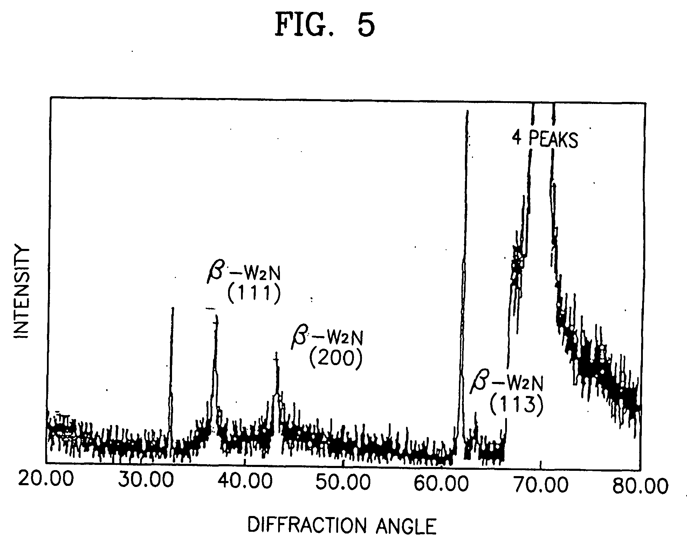

Therefore, the conclusion is that the WNₓ layer can be grown selectively in a contact hole only by adjusting the flow-rate ratio of the nitrogen-containing gas to the tungsten source gas. This is more obvious from FIG. 5 showing X-ray diffraction results of the WNₓ of FIG. 4C. In FIG. 5, three peaks of a ß-W₂N phase and different crystal orientations are shown, which indicates that the WNₓ layer is selectively formed on a silicon substrate.

### Method for manufacturing metal wiring

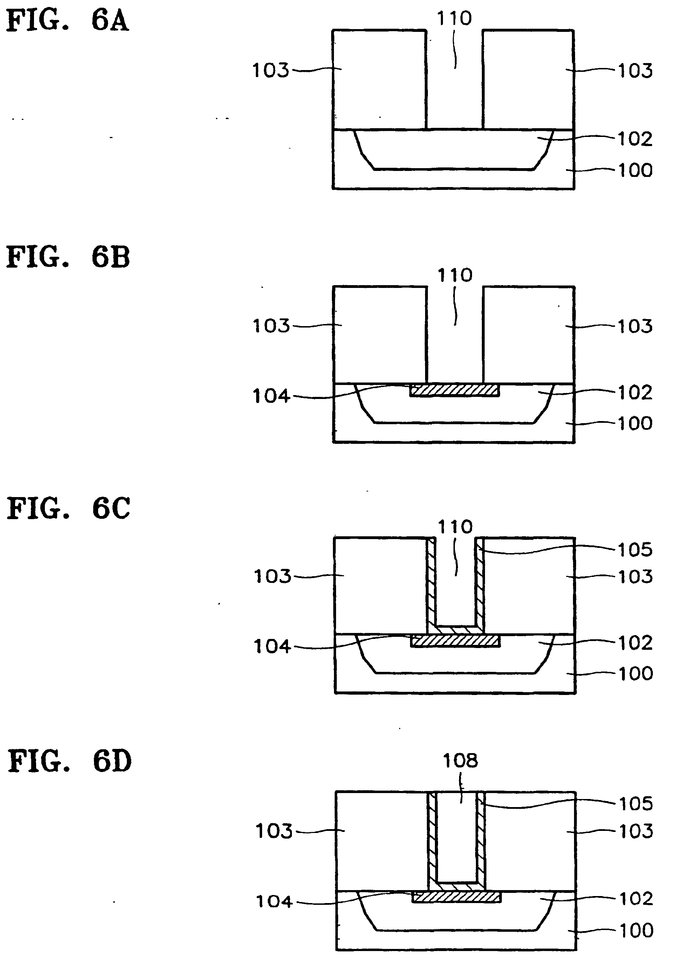

A method for manufacturing a metal wiring of a semiconductor device using the above WNₓ layer manufacturing method will be described with reference to FIGS. 6A to 8E.

### First example

Referring to FIG. 6A, an insulating layer 103, for example, a silicon oxide layer, is formed to a thickness of 500-2000Å on a silicon substrate 100 having an impurity region 102 formed therein. Here, the silicon oxide serving as the insulating layer 103 layer can be replaced with a silicon nitride layer or a layer obtained by implanting impurities into a silicon oxide layer or a silicon nitride layer. Then, a contact hole 110 is formed to expose the impurity region 102 by dry etching the insulating layer 103 by photolithography.

Referring to FIG. 6B, a Ti layer is deposited to a thickness of 200-1500Å on the insulating layer 103 and in the contact hole 110. Then the resultant structure is thermally treated so that the Ti layer reacts with the silicon substrate 100 exposed by the contact hole 110, thereby forming a TiSix layer 104 only on the contact surface between the contact hole 110 and the silicon substrate 100. The remaining Ti which did not react with the substrate is removed by wet etching. The TiSix layer 104 functions as an ohmic layer.

Referring to FIG. 6C, the silicon substrate 100 is heated to 200-700°C, and the substrate 100 exposed by the contact hole 110 and the sidewalls of the insulating layer 103 are selectively deposited with a WNₓ layer by flowing a nitrogen-containing gas, a tungsten source gas, and a reducing agent gas onto the silicon substrate 100. Here, the flow-rate ratio of the nitrogen-family gas to the tungsten source gas is 0.5-100, and the flow-rate ratio of the reducing agent gas to the tungsten source gas is 0-500.

Referring to FIG. 6D, after the WN layer 105 is formed, a thin metal layer 108 is deposited only in the contact hole 100 by an in-situ method, thereby forming a metal wiring. Here, the metal layer is preferably formed of one of a pure metal such as Al, W, Mo, Co, Ti, Cu, and Pt, their silicide compound, and their alloy.

### Second example

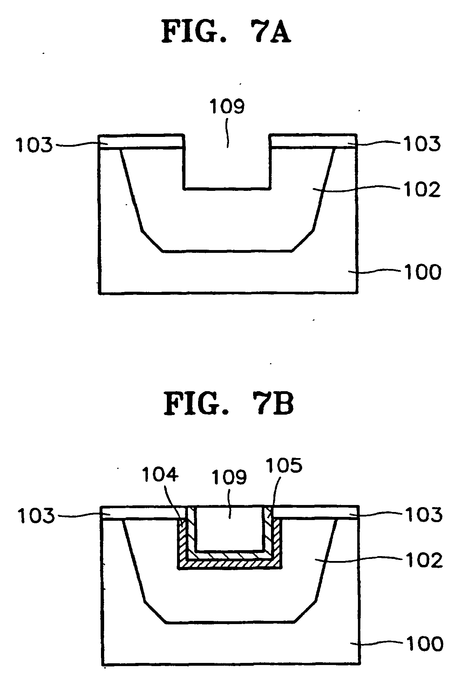

The second example is different from the first example in that a trench 109 is formed by etching the insulating layer 103 and the substrate 100 and then a metal wiring layer is formed as shown in FIG. 7A, instead of forming a metal wiring in the contact hole 110 of FIG. 6A formed by etching only an insulating layer. After the formation of the trench 109, in FIG. 7B, a TiSix layer 104 as an ohmic layer, a WNₓ layer 105 as a diffusion-barrier layer, and a tungsten layer 108 as a metal layer are formed in sequence thereby completing a metal wiring, in the same manner as for the first embodiment. The reason for forming the trench 109 is to overcome the problem of an increase in the aspect ratio of the contact hole.

### Third example

The third example is very different from the first and second examples in that instead of the TiSix layer as an ohmic layer, tungsten or a tungsten compound such as tungsten silicide is deposited by CVD thereby to lower contact resistance, and a WN layer as a diffusion-barrier layer is deposited in-situ by CVD.

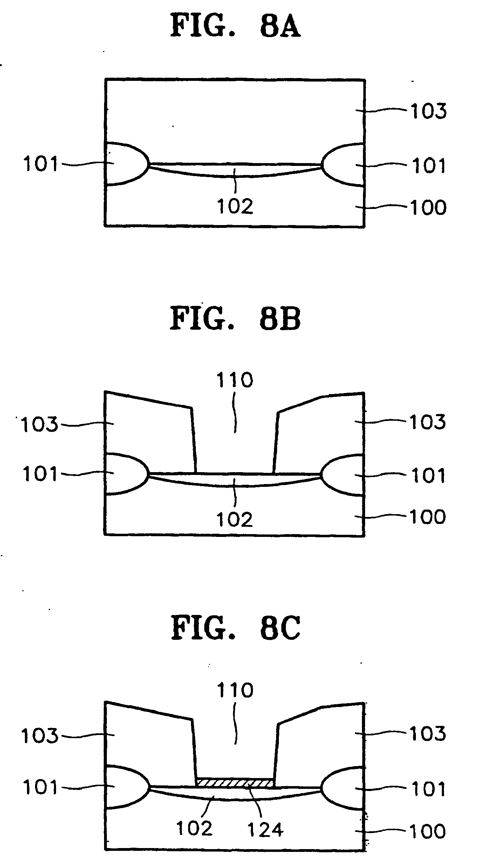

Referring to FIG. 8A, after a device isolation region 101 is formed on the silicon substrate 100 to isolate active regions from each other following a general device isolation process, an impurity region, for example, an N⁺ or P⁺ junction 102 is formed in an active region by ion implantation. Subsequently, the insulating layer 103, for example, BPSG is coated on the resultant so that steps are planarized.

Referring to FIG. 8B, the insulating layer 103 is etched by photolithography and the contact hole 110 is formed to expose the impurity region 102 of the silicon substrate 100.

Referring to FIG. 8C, a tungsten-containing ohmic layer 124 is formed by CVD on the resultant including the contact hole 110. Here, the ohmic layer 124 can be formed in the following four ways:
(1) the tungsten ohmic layer 124 is deposited by flowing a tungsten source gas for a short enough time to not result in encroachment on the silicon;
(2) in an initial deposition, the tungsten nitride ohmic layer 124 is formed to be thin and tungsten-abundant only on the bottom of a contact hole by setting the flow-rate ratio of a nitrogen-containing gas to a tungsten source gas to 2 or below, to prevent encroachment on the silicon. Then, the WNₓ layer 125 is formed in the contact hole 110 by increasing the flow rate of the nitrogen-containing gas so as to set the flow-rate ratio of the nitrogen-family gas to the tungsten source gas to 2-100, more preferably 2-7. Thus, the encroachment on silicon can be prevented and the WN layer can be selectively formed only in the contact hole;
(3) the ohmic layer 124 is formed by mixing SiH₄ or SiH₂Cl₂ with the tungsten source gas, depositing the mixture gas at 500°C or above, and thus forming tungsten silicide; and
(4) the barrier metal of the WNₓ layer is directly deposited on a silicon substrate and annealed so that tungsten of the WN layer reacts with an underlying silicon, thereby forming tungsten silicide as the ohmic layer 124.

Option (3) above describes a method of forming the ohmic layer according to an embodiment of the present invention.

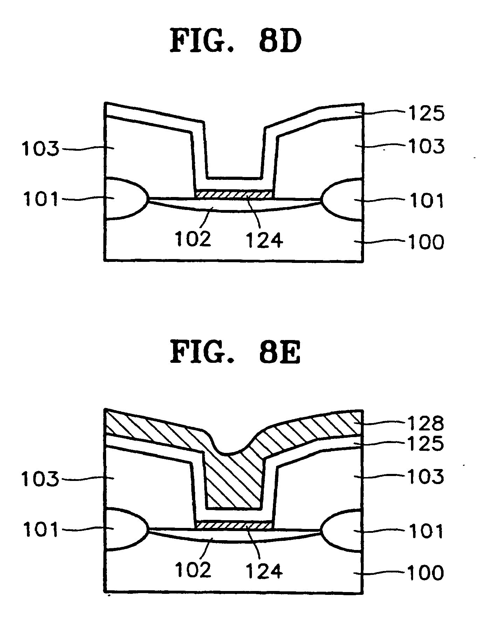

Referring to FIG. 8D, a diffusion-barrier layer 125, that is, the WN layer is deposited to a thickness of 500Å or above in the same chamber in which the ohmic layer 124 is deposited in the same manner as that of the first example.

Referring to FIG. 8E, a metal wiring layer 128 is deposited on the resultant having the diffusion-barrier layer 125 formed thereon. The metal wiring layer 128 is preferably formed by depositing a wiring metal such as Al or Cu.

Therefore, as described above, a WNₓ layer can be formed selectively on only the sidewalls of a contact hole and on silicon substrate exposed by the contact hole or an underlying metal wiring layer, and not on the insulating layer. Thus, the lifting that occurs for a conventional metal wiring layer can be prevented due to similar physical characteristics of both tungsten nitride and tungsten layers by forming the W layer as a metal wiring layer after formation of the WNₓ layer as a diffusion-barrier layer. When an ohmic layer is formed according to the third example, substrate encroachment is overcome and a stable semiconductor device can be formed at a subsequent high temperature process. In addition, the increase of contact resistance resulting from the formation of the ohmic layer using a Ti layer can be prevented.

The present invention is illustrated above. It is clearly understood by anyone skilled in the art that many variations are possible within the scope of the present invention as claimed.

## Claims

1. A method of manufacturing a metal wiring for a semiconductor device, comprising the steps of:
(a) forming an insulating layer (103) on a semiconductor substrate (100) having a conductive layer (102) formed thereon;
(b) forming a contact hole (110) by etching said insulating layer (103) to expose said conductive layer (102);
(c) forming an ohmic layer by depositing tungsten silicide (124) on the conductive layer (102) exposed by said contact hole (110);
(d) forming a diffusion-barrier layer (125) by subsequently selectively depositing a tungsten nitride layer in-situ on said ohmic layer (124)and sidewalls of the contact hole (110) by reacting a nitrogen-containing gas and a tungsten source gas by controlling flow rates of the gases such that the flow rate of the nitrogen-containing gas is from 2 to 7 times the flow rate of the tungsten source gas, so as to prevent formation of a tungsten nitride layer on the insulating layer (103) outside the contact hole (110); and
(e) depositing a metal layer (128) on said diffusion barrier layer (125).

2. A method of manufacturing a metal wiring for a semiconductor device as claimed in claim 1, wherein said conductive layer (102) is one of a silicon substrate doped with P⁺ impurities; a metal wiring layer which is formed of one of aluminum (Al), tungsten (W), molybdenum (Mo), cobalt (Co), titanium (Ti), copper (Cu), platinum (Pt), a silicide compound of said metals; and an alloy of said metals.

3. A method of manufacturing a metal wiring for a semiconductor device as claimed in claim 1 or 2, wherein said insulating layer (103) is formed of one of a silicon oxide layer, a silicon nitride layer, and a layer obtained by implanting impurities into one of said silicon oxide layer and said silicon nitride layer.

4. A method of manufacturing a metal wiring for a semiconductor device as claimed in any of claims 1 to 3, wherein said steps (d) and (e) are performed in-situ in the same chamber.

5. A method of manufacturing a metal wiring for a semiconductor device as claimed in any of claims 1 to 4, wherein said tungsten source gas is one of WF₆ and WCl₆.

6. A method of manufacturing a metal wiring for a semiconductor device as claimed in any of claims 1 to 5, wherein said nitrogen-containing gas is one of N₂, NH₃, and methyl hydrazine.

7. A method of manufacturing a metal wiring for a semiconductor device as claimed in any of claims 1 to 6, wherein step (d) comprises reacting a gas mixture of said nitrogen-containing gas and said tungsten source gas with a reducing agent gas, and wherein the flow-rate ratio of said reducing agent gas to said tungsten source gas is up to 500:1.

8. A method of manufacturing a metal wiring for a semiconductor device as claimed in any of claims 1 to 7, wherein said metal layer is formed of one of aluminum (Al), tungsten (W), molybdenum (Mo), cobalt (Co), titanium (Ti), copper (Cu), platinum (Pt), a silicide compound of said metals, and an alloy of said metals.

9. A method of manufacturing a metal wiring for a semiconductor device as claimed in claim 7, wherein said reducing agent gas is one of H₂, SiH₄, SiH₁Cl₃, SiH₂Cl₂, and PH₃.

## Patentansprüche

1. Verfahren zur Herstellung einer metallischen Leiterbahn für eine Halbleiteranordnung, umfassend die Schritte:
(a) Ausbilden einer Isolierschicht (103) auf einem Halbleitersubstrat (100) mit einer darauf ausgebildeten leitfähigen Schicht (102),
(b) Ausbilden eines Kontaktdurchtritts (110) durch Ätzen der Isolierschicht (103) zum Freilegen der leitfähigen Schicht (102);
(c) Ausbilden einer ohmischen Schicht durch Abscheiden von Wolframsilicid (124) auf der leitfähigen Schicht (102), die durch den Kontaktdurchtritt (110) freigelegt ist;
(d) Ausbilden einer Diffusionsbarrierenschicht (125) durch anschlie-ßendes selektives Abscheiden in situ einer Wolframnitridschicht auf der ohmischen Schicht (124) und Seitenwänden des Kontaktdurchtritts (110) durch Umsetzen eines Stickstoff enthaltenden Gases und eines Wolframquellengases durch Steuern der Strömungsraten der Gase in der Weise, dass die Strömungsrate des Stickstoff enthaltenden Gases von 2- bis 7-fach der Strömungsrate des Wolframquellengases beträgt, so dass Bildung einer Wolframnitridschicht auf der Isolierschicht (103) außerhalb des Kontaktdurchtritts (110) vermieden wird; und
(e) Abscheiden einer Metallschicht (128) auf der Diffusionsbarrierenschicht (125).

2. Verfahren zur Herstellung einer metallischen Leiterbahn für eine Halbleiteranordnung nach Anspruch 1, worin die leitfähige Schicht (102) eines von einem Siliciumsubstrat dotiert mit P⁺-Fremdstoffen ist; eine Metallleiterbahnschicht, die gebildet ist aus einem von Aluminium (Al), Wolfram (W), Molybdän (Mo), Cobalt (Co), Titan (Ti), Kupfer (Cu), Platin (Pt), einer Silicidverbindung der Metalle; und einer Legierung der Metalle.

3. Verfahren zur Herstellung einer metallischen Leiterbahn für eine Halbleiteranordnung nach Anspruch 1 oder 2, worin die Isolierschicht (103) ausgebildet wird auf einem von einer Siliciumoxidschicht, einer Siliciumnitridschicht und einer Schicht, die durch Implantieren von Fremdstoffen in eines von der Siliciumoxidschicht und der Siliciumnitridschicht ausgebildet ist.

4. Verfahren zur Herstellung einer metallischen Leiterbahn für eine Halbleiteranordnung nach einem der Ansprüche 1 bis 3, worin die Schritte (d) und (e) in situ in der selben Kammer durchgeführt werden.

5. Verfahren zur Herstellung einer metallischen Leiterbahn für eine Halbleiteranordnung nach einem der Ansprüche 1 bis 4, worin das Wolframquellengas eines von WF₆ und WCl₆ ist.

6. Verfahren zur Herstellung einer metallischen Leiterbahn für eine Halbleiteranordnung nach einem der Ansprüche 1 bis 5, worin das Stickstoff enthaltende Gas eines von N₂, NH₃ und Methylhydrazin ist.

7. Verfahren zur Herstellung einer metallischen Leiterbahn für eine Halbleiteranordnung nach einem der Ansprüche 1 bis 6, worin Schritt (d) Umsetzen eines Gasgemischs des Stickstoff enthaltenden Gases und des Wolframquellengases mit einem Reduktionsmittelgas umfasst, und worin das Strömungsratenverhältnis des Reduktionsmittelgases zum Wolframquellengas bis zu 500:1 beträgt.

8. Verfahren zur Herstellung einer metallischen Leiterbahn für eine Halbleiteranordnung nach einem der Ansprüche 1 bis 7, worin die Metallschicht aus einem von Aluminium (Al), Wolfram (W), Molybdän (Mo), Cobalt (Co), Titan (Ti), Kupfer (Cu), Platin (Pt), einer Silicidverbindung der Metalle und einer Legierung der Metalle gebildet wird.

9. Verfahren zur Herstellung einer metallischen Leiterbahn für eine Halbleiteranordnung nach Anspruch 7, worin das Reduktionsmittelgas eines von H₂, SiH₄, SiH₁Cl₃, SiH₂Cl₂ und PH₃ ist.

## Revendications

1. Procédé pour fabriquer un câblage métallique pour un dispositif semi-conducteur, comprenant les étapes consistant à :
(a) former une couche isolante (103) sur un substrat semi-conducteur (100) ayant une couche conductrice (102) formée dessus ;
(b) former un trou de contact (110) par gravure de ladite couche isolante (103) pour exposer ladite couche conductrice (102) ;
(c) former une couche ohmique par déposition de siliciure de tungstène (124) sur la couche conductrice (102) exposée par ledit trou de contact (110) ;
(d) former une couche formant barrière à la diffusion (125) par déposition sélective subséquente d'une couche de nitrure de tungstène in situ sur ladite couche ohmique (124) et les parois latérales du trou de contact (110) par réaction d'un gaz azoté et d'un gaz de source de tungstène par contrôle des débits des gaz de telle sorte que le débit du gaz azoté soit de 2 à 7 fois le débit du gaz de source de tungstène, de façon à empêcher la formation d'une couche de nitrure de tungstène sur la couche isolante (103) à l'extérieur du trou de contact (110) ; et
(e) déposer une couche métallique (128) sur ladite couche formant barrière à la diffusion (125).

2. Procédé pour fabriquer un câblage métallique pour un dispositif semi-conducteur selon la revendication 1, dans lequel ladite couche conductrice (102) est l'une parmi un substrat en silicium dopé avec des impuretés P⁺ ; une couche de câblage métallique qui est formée de l'un parmi l'aluminium (Al), le tungstène (W), le molybdène (Mo), le cobalt (Co), le titane (Ti), le cuivre (Cu), le platine (Pt), un composé siliciure desdits métaux ; et un alliage desdits métaux.

3. Procédé pour fabriquer un câblage métallique pour un dispositif semi-conducteur selon la revendication 1 ou 2, dans lequel ladite couche isolante (103) est formée de l'une parmi une couche en oxyde de silicium, une couche en nitrure de silicium, et une couche obtenue par implantation d'impuretés dans l'une parmi ladite couche en oxyde de silicium et ladite couche en nitrure de silicium.

4. Procédé pour fabriquer un câblage métallique pour un dispositif semi-conducteur selon l'une quelconque des revendications 1 à 3, dans lequel lesdites étapes (d) et (e) sont effectuées in situ dans la même chambre.

5. Procédé pour fabriquer un câblage métallique pour un dispositif semi-conducteur selon l'une quelconque des revendications 1 à 4, dans lequel ledit gaz de source de tungstène est l'un parmi WF₆ et WCl₆.

6. Procédé pour fabriquer un câblage métallique pour un dispositif semi-conducteur selon l'une quelconque des revendications 1 à 5, dans lequel ledit gaz azoté est l'un parmi N₂, NH₃, et la méthylhydrazine.

7. Procédé pour fabriquer un câblage métallique pour un dispositif semi-conducteur selon l'une quelconque des revendications 1 à 6, dans lequel l'étape (d) comprend la réaction d'un mélange gazeux dudit gaz azoté et dudit gaz de source de tungstène avec un gaz d'agent réducteur, et dans lequel le rapport de débit dudit gaz d'agent réducteur audit gaz de source de tungstène va jusqu'à 500/l.

8. Procédé pour fabriquer un câblage métallique pour un dispositif semi-conducteur selon l'une quelconque des revendications 1 à 7, dans lequel ladite couche métallique est formée de l'un parmi l'aluminium (Al), le tungstène (W), le molybdène (Mo), le cobalt (Co), le titane (Ti), le cuivre (Cu), le platine (Pt), un composé siliciure desdits métaux, et un alliage desdits métaux.

9. Procédé pour fabriquer un câblage métallique pour un dispositif semi-conducteur selon la revendication 7, dans lequel ledit gaz d'agent réducteur est l'un parmi H₂, SiH₄, SiH₁Cl₃, SiH₂Cl₂, et PH₃.
